# FASCICULE DE BREVET EUROPEEN

(11) **EP 3 671 269 B1**
(45) Date de publication et mention de la délivrance du brevet: **30.03.2022**
(21) Numéro de dépôt: 19211425.4
(22) Date de dépôt: 26.11.2019
(51) Int. Cl.: G01S 13/78, G01S 13/44, G01R 29/10, G01S 7/40

(54) **PROCEDE DE MESURE DE PRECISION AZIMUT ET DE DIAGRAMMES DU LOBE PRINCIPAL D'ANTENNE D'UN RADAR SECONDAIRE, ET RADAR METTANT EN OEUVRE UN TEL PROCEDE**
VERFAHREN ZUR AZIMUTPRÄZISIONSMESSUNG UND DER HAUPTKEULE IN EINEM ANTENNENDIAGRAMM EINES SEKUNDÄREN RADARS, UND RADAR, DER DIESES VERFAHREN ANWENDET
METHOD FOR MEASURING PRECISION AZIMUTH AND MAIN LOBE PATTERNS OF A SECONDARY RADAR ANTENNA AND RADAR IMPLEMENTING SUCH A METHOD

(30) Priorité: 18.12.2018 FR 1873035
(43) Date de publication de la demande: 24.06.2020
(73) Titulaire: Thales, 92400 Courbevoie (FR)
(72) Inventeur: BILLAUD, Philippe, 91470 Limours (FR)
(74) Mandataire: Marks & Clerk France

(56) Documents cités:
- EP-A1- 2 960 671
- US-A1- 2008 042 896
- US-A1- 2012 001 793

## Description

La présente invention concerne un procédé de mesure de diagrammes d'antenne et de la précision azimut de la fonction écartométrie de radars secondaires. Elle concerne également un radar secondaire mettant en œuvre un tel procédé.

Le domaine privilégié de l'invention est le Contrôle du Trafic Aérien (ATC) pour lequel la performance du radar est fondamentale tant au niveau de la détection des aéronefs que de la localisation très précise des cibles en azimut jusqu'à plusieurs centaines de kilomètres.

Ces performances de précision sont particulièrement liées à la qualité des diagrammes de l'antenne équipant les radars secondaires employés en ATC ou en IFF.

Dans la suite de la description, dans un but de simplification, on appellera par extension antenne l'ensemble constitué :
- principalement de l'antenne du radar de tout type, Large Vertical Aperture LVA ou poutre ;
- du joint tournant associant partie rotative et partie fixe du radar ;
- des câbles de la descente d'antenne.

Actuellement, la mesure de la précision azimut d'un radar secondaire nécessite une balise externe dont le radar exploite les réponses pour la localiser et par suite contrôler le bon fonctionnement de la fonction d'écartométrie du radar.

Une mesure plus indépendante du radar de la qualité des diagrammes du lobe principal d'une antenne (sensiblement compris entre -10° et +10° en ATC) installée sur un site radar nécessite à la fois :
- le passage en maintenance de la station, ce qui diminue la couverture radar au niveau système ;
- d'employer un outillage externe pour mesurer en réception (à 1090MHz) les diagrammes de l'antenne SUM, CONT et DIFF ;
ceci n'étant usuellement effectué que pour une valeur d'élévation qui est celle de l'outillage, en général très proche du radar, donc à une valeur très faible d'élévation souvent proche de zéro (même hauteur que le radar) alors que les avions se situent principalement entre 0,5° et 20° selon le type d'emploi du radar (configuration « Airport » ou « En Route »).

En l'absence de mesures périodiques préventives des diagrammes d'antennes et de la précision azimut du radar, ou même entre deux sessions de mesures préventives, la dégradation de ces diagrammes n'est alors perçue par l'utilisateur que lorsque les performances du radar sont dégradées, quelquefois au point de ne plus remplir sa mission. Dans ce cas, l'interruption de service est alors imposée et la réparation de l'antenne est à effectuer en urgence sachant qu'il s'agit de la plus importante et compliquée tâche de maintenance d'un radar.

On rappelle que l'écartométrie est une méthode de mesure de dépointage d'une cible, présente dans le faisceau principal, par rapport à l'axe de l'antenne et que le radar secondaire se devant d'assurer, dans sa mission première, la localisation, de toutes les cibles détectées, très précise à la fois en distance et azimut par rapport au radar, sa fonction d'écartométrie lui est fondamentale car contribuant directement à sa précision azimut.

Un document US 2008/0042896 A1 divulgue un procédé de construction d'une table de calibration monopulse à partir de cibles d'intérêts reçues dans les voies somme et différence d'un radar secondaire.

Un but de l'invention est notamment de permettre de mesurer la précision azimutale des diagrammes d'antenne d'un radar secondaire, et par là-même d'évaluer leur dégradation.

A cet effet, l'invention a pour objet un procédé de mesure des diagrammes d'antenne et d'écartométrie par tranches d'élévation d'un radar secondaire, chaque diagramme étant associé à une voie de réception, caractérisé en ce que, sur une période de temps donnée :
- on détecte les réponses asynchrones non sollicitées, de type squitters ADS-B longs, émises par des cibles présentes dans l'environnement aérien dudit radar, chacun desdits squitters contenant une information de position 3 D de la cible qui l'émet ;
- pour chaque détection, on décode le squitter ADS-B longs pour vérifier que la cible détectée est localisée conformément à l'information de position contenue dans ledit squitter, les détections non conformes étant rejetées ;
- pour chaque détection retenue, l'heure de ladite détection, la valeur de l'azimut de l'axe du faisceau principal de ladite antenne, la tension d'écartométrie et la valeur de puissance reçue sur chacune desdites voies de réception SUM, DIFF, CONT_Front, CONT_Back sont associées à ladite détection, l'information de position contenue dans ledit squitter donnant par calcul la tranche d'élévation dans laquelle est située ladite détection ;
lesdites valeurs obtenues sur ladite période étant mémorisées, les diagrammes mesurés et les mesures d'écartométrie étant échantillonnés, par tranche d'élévation, à partir desdites valeurs mémorisées.

Ladite antenne comporte par exemple un des ensembles de diagrammes suivant :
- un diagramme somme (SUM), un diagramme différence (DIFF), un diagramme de contrôle pour rejeter des réponses de cibles face à l'antenne (CONT_Front) et un diagramme de contrôle pour rejeter des cibles à l'arrière de l'antenne (CONT_Back) ;
- un diagramme somme (SUM), un diagramme différence (DIFF), un diagramme de contrôle (CONT) ;
- un diagramme somme (SUM) et un diagramme différence et contrôle (DIFF/CONT).

Dans un mode de mise en œuvre particulier, les réponses de type squitters ADS-B longs sont enrichies par des caractéristiques représentatives de l'acquisition desdites réponses, lesdites caractéristiques étant pour chaque réponse au moins l'une des caractéristiques suivantes :
- la puissance reçue selon chaque diagramme de ladite antenne ;
- l'écartométrie de la réponse dans le lobe principal de la dite antenne ;
- l'heure de la détection de ladite réponse ;
- l'azimut de l'axe du faisceau principal de ladite antenne lors de ladite détection.

Par exemple, pour chaque squitter reçu dans le faisceau principal, ledit procédé :
- exploite l'information contenue dans le squitter ;
- calcule la puissance relative puis l'erreur du gain des diagrammes de l'antenne en fonction du gisement :
   - dans le même faisceau, ledit radar mesurant la puissance du plot synchrone, ladite puissance étant la valeur maximum du diagramme somme ;
   - la réponse squitter ADS-B long étant enrichie d'une mesure de puissance sur les diagrammes somme, différence et contrôle, le procédé selon l'invention déduisant pour le gisement du squitter :
      ∘ SUM-relative (dB) = SUM (en dBm) - SUM_max (en dBm) ;
      ∘ DIFF-relative (dB) = DIFF (en dBm) - SUM_max (en dBm) ;
      ∘ CONT-relative (dB) = CONT (en dBm) - SUM_max (en dBm) ;
   - l'erreur de gain de chaque diagramme est établie en comparant ces valeurs à celles de référence de l'invention (diagrammes mesurées soit lors de la recette du radar en usine, soit lors de l'acceptation du site radar) :
      ∘ SUM_err (dB) = SUM-relative (dB) - SUM-reference (dB) ;
      ∘ DIFF_err (dB) = DIFF-relative (dB) - DIFF-reference (dB) ;
      ∘ CONT_err (dB) = CONT-relative (dB) - CONT-reference (dB) ;
- calcule l'erreur d'écartométrie en tenant compte de la déformation du faisceau en élévation relative à l'antenne.

Pendant la durée de l'analyse, lesdites valeurs sont par exemple accumulées en fonction du gisement au fur et à mesure selon :
- l'azimut de ladite antenne ;
- l'élévation de ladite cible.

Sur ladite période donnée, on accumule par exemple dans des tables à trois entrées l'erreur d'écartométrie et l'erreur de chaque diagrammes, une table étant associée à l'erreur d'écartométrie et à l'erreur de chaque diagramme d'antenne, une entrée étant le gisement en fonction de l'axe du lobe principal de l'antenne, la seconde entrée étant l'élévation de la cible en fonction de l'horizontalité de l'antenne et la troisième entrée étant l'azimut antenne.

Chaque cellule (gisement, élévation) de l'erreur d'écartométrie et de l'erreur de chaque diagramme est par exemple établie par des méthodes du type moyenne, histogramme ou autres.

Ladite période donnée est par exemple définie pour laisser apparaître des dégradations en cours desdits diagrammes.

Sous contrôle d'un opérateur ou automatiquement, ledit radar employant une table d'écartométrie pour localiser les cibles synchrones en azimut dans ledit faisceau principal, ladite table est par exemple corrigée sur la base des erreurs d'écartométrie mesurées afin d'assurer une bonne précision azimutale dudit radar lors d'une dégradation de l'ensemble de composants dit aérien.

L'antenne, équipant un radar secondaire du type ATC ou IFF, comporte par exemple au moins deux diagrammes. Ladite antenne est à balayage électronique, fixe ou tournante.

Les mesures de l'erreur d'écartométrie et des diagrammes d'antenne sont par exemple utilisées pour évaluer le niveau de dégradation de chaque élément de l'aérien : antenne, câbles de la descente d'antenne, joint tournant.

La mesure desdits diagrammes est par exemple utilisée pour évaluer le niveau de dégradation de l'ensemble de composants dit aérien.

L'invention a également pour objet un radar secondaire mettant en œuvre un tel procédé.

D'autres caractéristiques et avantages de l'invention apparaîtront à l'aide de la description qui suit, faite en regard de dessins annexés qui représentent :
- la figure 1, un exemple de synoptique d'un radar secondaire mode S ;
- la figure 2, une illustration de la mise en œuvre matérielle de l'invention ;
- la figure 3, une illustration d'un exemple d'antenne ATC ;
- la figure 4, une illustration, par un exemple, du fonctionnement synchrone typique d'un radar secondaire ;
- la figure 5, une illustration de la puissance reçue en fonction de la distance de la cible ;
- la figure 6, une illustration du principe de l'invention par un exemple d'échantillonnage des diagrammes d'une antenne par des squitters, asynchrones, émis par différentes cibles ;
- la figure 7, des exemples de diagrammes mesurés par le procédé selon l'invention ;
- la figure 8, une courbe de tension d'écartométrie en fonction du dépointage de la cible dans le lobe principal ;
- la figure 9, une courbe d'erreur de précision azimut du radar en fonction du dépointage de la cible dans le lobe principal ;
- la figure 10, une nouvelle courbe d'erreur de précision azimut du radar en fonction du dépointage suite au calcul d'une nouvelle table d'écartométrique selon l'invention ;
- la figure 11, un zoom sur la partie utile du lobe principal comparant l'erreur de précision azimut du radar en fonction du dépointage entre l'ancienne et la nouvelle table d'écartométrique selon l'invention.

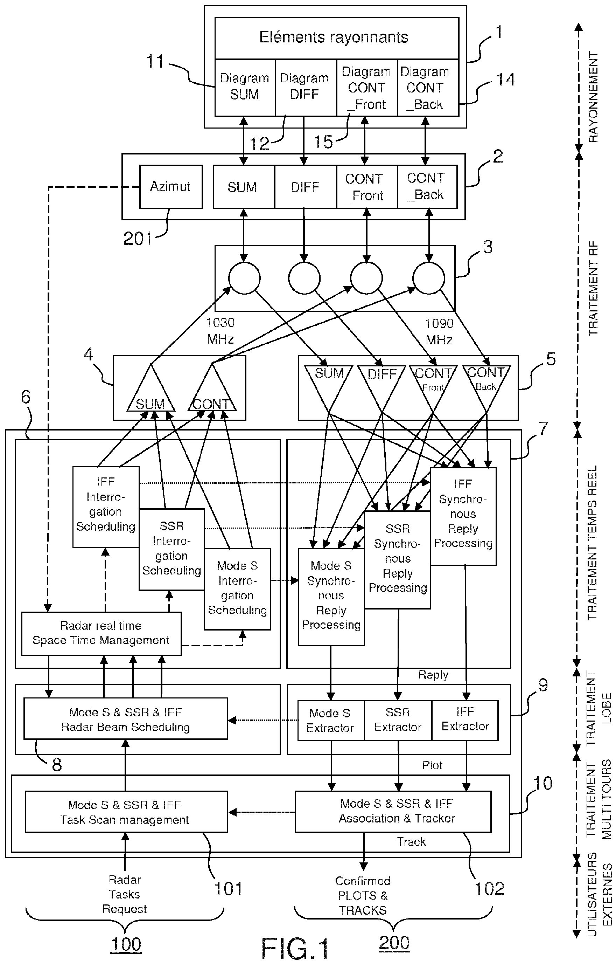

En regard de la figure 1 qui représente un exemple de synoptique d'un radar mode S, on rappelle les principes d'un tel radar.

Le principe du radar secondaire mode S (défini en détail par l'ICAO Annexe 10 vol.4) consiste à :
- émettre des interrogations sélectives :
   - soit indiquant le destinataire : une seule cible désignée par son adresse Mode S ;
   - soit indiquant l'identifiant de l'émetteur ;
- recevoir des réponses sélectives :
   - soit indiquant l'identifiant de l'émetteur : la même adresse Mode S de la cible ;
   - soit indiquant le destinataire : l'identifiant de l'interrogateur.

Dans son emploi usuel, le radar secondaire fonctionne en mode synchrone, c'est-à-dire qu'il émet une interrogation et attend une réponse en cohérence avec celle-ci, ce qui lui permet de localiser par mesure (en azimut et distance) et d'identifier (par l'adresse mode S) la cible.

Pour effectuer cette tâche avec performance, le radar est équipé d'une antenne 1 (figure 1) ayant plusieurs diagrammes 11, 12, 14, 15 dont les rôles sont classiquement :
- un diagramme somme 11, noté par la suite SUM, pour interroger et détecter la réponse synchrone de la cible ;
- un diagramme différence 12, noté DIFF, pour localiser finement la cible dans le faisceau SUM ;
- un premier diagramme de contrôle 15, noté CONT_Front, pour bloquer et réjecter les réponses issues de cibles face à l'antenne non présentes dans le faisceau principal de SUM ;
- un deuxième diagramme de contrôle 14, noté CONT_back, pour bloquer et réjecter les réponses issues de cibles au dos à l'antenne (donc forcément non présentes dans le faisceau principal de SUM).

Selon les missions et donc les performances attendues du radar les antennes peuvent être :
- de plusieurs diagrammes :
   - 4 diagrammes : SUM, DIFF, CONT_Front & CONT_Back ;
   - 3 diagrammes : SUM, DIFF, CONT (CONT_Front et CONT_Back sont regroupés au niveau de l'antenne) ;
   - 2 diagrammes : SUM, DIFF/CONT (DIFF, CONT_Front & CONT_Back sont regroupés au niveau de l'antenne).
- de dimensions différentes :
   - en largeur :
      ∘ ayant une grande largeur pour avoir un faisceau principal fin apportant un fort gain ainsi que pour être sélective et précise en azimut ;
   - en hauteur :
      ∘ ayant une grande hauteur, de type Large Vertical Aperture (LVA) apportant du gain et une protection contre les réflexions sol (principalement en ATC) ;
      ∘ ayant une petite hauteur, de type « poutre » apportant une mobilité (principalement utilisée en IFF).

Alors que les diagrammes SUM et DIFF sont classiquement fins avec des lobes à 3dB entre 2,4° à 10°, les diagrammes CONT_Front et CONT_Back cherchent à couvrir pratiquement 180° chacun.

Les antennes peuvent aussi être :
- de diagramme fixe, dites « mécanique » et tournante ;
- de diagramme évolutif, à balayage électronique, dites « AESA » fixe ou tournante.

Dans la suite de la description, on décrit la configuration antennaire la plus complète, soit 4 diagrammes en antenne tournante, sachant que les autres configurations se traitent de façon similaire quel que soit le nombre de diagrammes d'antennes exploités que l'antenne soit tournante ou fixe. Pour simplifier la description, on pourra cependant utiliser la configuration à 3 diagrammes en utilisant CONT en tant que regroupement de CONT_Front et CONT_Back.

Dans son utilisation opérationnelle, le radar reçoit des réponses non sollicitées (sans interrogation associée de sa part), celles-ci sont nommées « False Reply Unsynchronized in Time » ou Fruit. Elles sont ainsi nommées car :
- elles ne sont pas attendues par le radar qui les rejette (« False ») ;
- elles sont des réponses très similaires à celles synchrones et issues des mêmes cibles dans la même couverture du radar, ayant même fréquence et même format de message (« Reply ») ;
- elles ne sont pas associées à une interrogation de ce radar, mais d'un autre radar ou même émise par la cible de façon périodique telles que les squitters ADS-B (« Unsynchronized in Time »).

De par leur caractéristique asynchrone les Fruits sont reçus par le radar sur tous ses diagrammes d'antenne.

Enfin, les Fruits Mode S sont tous identifiables par l'unique adresse Mode S associée à chaque cible.

Alors que les Fruits générés par un radar secondaire sont actuellement traités comme des défauts qui doivent être filtrés avant traitement, l'invention exploite avantageusement les Fruits que sont les squitters ADS-B longs au cours du traitement pour mesurer la précision écartométrique du radar ainsi que les diagrammes d'antenne.

En conclusion, la mesure des diagrammes du lobe principal d'une antenne s'effectue en continu sans aucune influence sur le fonctionnement opérationnel du radar et est applicable quel que soit le type des antennes décrites.

Parmi les Fruits mode S que reçoit un radar les squitters ADS-B ne sont pas sollicités par un autre interrogateur (radar, WAM, ...) mais générés sans sollicitation par l'avion lui-même pour signaler sa présence et dans le cas des squitters ADS-B longs (DF17) pour de plus donner leur position calculée avec précision en exploitant les signaux GPS.

Le principe fondamental du récepteur de squitters ADS-B longs utilisant le même protocole mode S (messages définis en détail par l'ICAO Annexe 10 vol.4) consiste à :
- recevoir des Réponses Sélectives Non Sollicitées donc Asynchrones :
   - indiquant l'identifiant de l'émetteur : la même adresse Mode S (champ de 24bits) de la cible que celle transmise au radar lors des interrogations et réponses sélectives décrites ci-avant ;
   - la nature du contenu du message (DF=17) est variable selon le champ TC du message :
      ∘ 1 à 4 "Aircraft identification"
      ∘ 5 à 8 "Surface position"
      ∘ 9 à 18 "Airborne position (Baro Alt)"
      ∘ 19 "Airborne velocities "
      ∘ 20 à 22 "Airborne position (GNSS Height)"
      ∘ 23 "Test message"
      ∘ 24 "Surface system status"
      ∘ 25 à 27 "Reserved"
      ∘ 28 "Extended squitter AC status"
      ∘ 29 "Target state and status (V.2)"
      ∘ 30 "Reserved "
      ∘ 31 "Aircraft Opération status".

La liste ci-dessus est donnée à titre d'exemple, elle est indicative et évolutive.

L'invention exploite particulièrement les squitters DF17 du champ TC correspondant de 9 à 18 ou de 20 à 22 donnant la position en 3 dimensions de la cible équipée du transpondeur diffusant le squitter associé à une altitude soit barométrique soit GNSS.

Dans son emploi usuel, un récepteur ADS-B_in fonctionne donc en mode asynchrone, c'est-à-dire qu'il écoute sur 360° un message mode S très similaire à celui du radar pour la localisation (azimut et distance) et l'identification (adresse mode S) d'une cible.

Pour effectuer cette tâche avec performance, le récepteur ADS-B_in est équipé :
- soit d'une antenne omnidirectionnelle couvrant 360°, ce qui est une configuration courante ;
- soit de plusieurs antennes de large diagramme couvrant 360° au total:
   - deux antennes de couverture supérieure 180° dos à dos, qui est la configuration la plus répandue ;
   - plus rarement de trois antennes de couverture supérieure à 120° ou encore quatre antennes de couverture supérieure à 90° ;
dont le rôle est uniquement, par un diagramme unique (de type somme), de détecter la réponse asynchrone de la cible et d'en décoder le contenu, selon les formats rappelés ci-dessus.

Etant donné que le radar secondaire et le récepteur ADS-B exploitent des messages quasi identiques (même fréquence 1090MHz, même forme d'onde, même structure de données du message de la réponse) il est aisé d'intégrer au radar la fonction d'écoute des squitters ADS-B asynchrones en écoutant ceux-ci par les différents diagrammes de l'antenne du radar et cela principalement, mais pas uniquement, par le diagramme omnidirectionnel :
- par plusieurs récepteurs chacun associé à un diagramme de son antenne :
   - pour une antenne à 4 diagrammes : SUM, DIFF, CONT_Front & CONT_Back ;
   - pour une antenne à 3 diagrammes : SUM, DIFF, CONT ;
   - pour une antenne à 2 diagrammes : SUM, DIFF/CONT.

Dans le contexte de l'invention le radar est équipé selon cette configuration, à savoir un récepteur associé à chaque diagramme de son antenne, qu'elle comporte quatre, trois ou deux diagrammes.

Avant de décrire plus en détail l'invention, on décrit les éléments constitutifs du radar Mode S de la figure 1. Le synoptique fait apparaître le fonctionnement synchrone du radar Mode S :
- sur la partie gauche 100 par la génération des interrogations ;
- sur la partie droite 200 par le traitement synchrone des réponses associées,
ainsi que les synchronisations entre celles-ci par les flèches transverses entre gauche et droite.

Les fonctions des principaux éléments sont rappelées ci-après :
L'antenne 1 assure le rayonnement des interrogations à 1030 MHz et des réponses en retour à 1090 MHz, selon les quatre diagrammes : SUM, DIFF, CONT_Front et CONT_Back, ou trois diagrammes (SUM, DIFF, CONT) ou selon deux diagrammes (SUM, DIFF/CONT).

Un joint tournant 2 et des câbles de descente d'antenne, pour une antenne rotative, assurent :
- le couplage RF des signaux transmis à 1030 MHz et reçus à 1090 MHz indépendamment pour les quatre diagrammes entre la partie tournante et la partie fixe du radar ;
- la diffusion de la position en azimut 201 de l'axe du lobe principal de l'antenne.

Un traitement RF comporte :
- un duplexeur ou circulateur 3 assurant le couplage RF entre les signaux transmis à 1030 MHz et reçus à 1090 MHz indépendamment pour les quatre diagrammes ;
- un émetteur 4 assurant :
   - la transmission des interrogations à 1030 MHz sur le diagramme SUM ;
   - le blocage des transpondeurs en dehors du lobe SUM à 1030 MHz par les diagrammes CONT_Front et CONT_Back ;
   - ceci pour les différents protocoles secondaires : IFF, SSR et Mode S ;
- un récepteur 5 assurant la réception des réponses à 1090 MHz sur les quatre diagrammes SUM, DIFF, CONT_Front et CONT_Back, et le calcul de l'écartométrie pour les différents protocoles secondaires : IFF, SSR et Mode S.

Un traitement temps réel comporte :
- une gestion spatio-temporelle 6 assurant la gestion temps réel des périodes d'interrogations et d'écoutes associées pour les différents protocoles secondaires : IFF, SSR et Mode S ;
- un traitement du signal 7 assurant :
   - le traitement des réponses dans les périodes d'écoutes associées aux interrogations pour les différents protocoles secondaires : IFF, SSR et Mode S ;
   - la détection et le décodage des réponses synchrones dans le lobe principal de l'antenne en exploitant les quatre diagrammes :
      ∘ SUM : pour détecter les réponses reçues dans le lobe principal ;
      ∘ DIFF : pour localiser finement en azimut les réponses reçues dans le lobe principal SUM et éventuellement pour la discrimination de réponses emmêlées ;
      ∘ CONT_Front et CONT_Back : pour réjecter les réponses reçues sur les lobes secondaires de SUM et DIFF dans le cas d'une détection dans le lobe principal de SUM.

Un traitement dans le lobe principal de l'antenne comporte :
- une gestion 8 des cibles présentes dans le lobe, assurant :
   - la préparation des transactions (interrogations et réponses) à effectuer dans le prochain lobe pour les différents protocoles secondaires IFF, SSR et Mode S ;
   - le placement des interrogations et réponses Mode S dans la future période « Roll call » en fonction de l'état des transactions venant d'être effectuées ;
- des extracteurs 9 assurant la constitution de plots pour chacun des différents protocoles secondaires IFF, SSR et Mode S, à partir des réponses synchrones reçues dans le lobe selon le protocole employé lors des interrogations.

Un traitement multi tours 10 comporte :
- une gestion 101 des tâches Mode S à effectuer avec les cibles dans la couverture, assurant la prédiction de positions des cibles (rendez-vous d'antenne) et la préparation des tâches à effectuer avec ces positions selon les demandes internes, externes et l'état des transactions des tours précédents ;
- une association des plots et un pistage 102 des cibles dans la couverture assurant le pistage des cibles pour améliorer les performances (élimination des faux plots, contrôle de données décodées notamment) et pour prédire la position future de celles-ci.

Une interface avec les utilisateurs permet la prise en compte par le radar de différentes requêtes et la visualisation des plots et des poursuites de cibles.

Le principe d'interrogation sélective du mode S basé sur l'interrogation au tour suivant en utilisant la prédiction de position effectuée à partir des mesures antérieures est donc conceptuellement très sensible à la précision de ces mesures. Une erreur de position mesurée induit une erreur de position prédite du radar mode S au tour suivant pouvant conduire lors de celui-ci :
- soit à des interrogations sélectives inutiles car mal positionnées en azimut relativement à la position réelle de la cible ;
- soit au pire cas à la non détection de la cible dans ce tour.

Il est donc très important de « monitorer » la précision de la mesure azimutale du radar basée sur l'emploi de l'écartométrie.

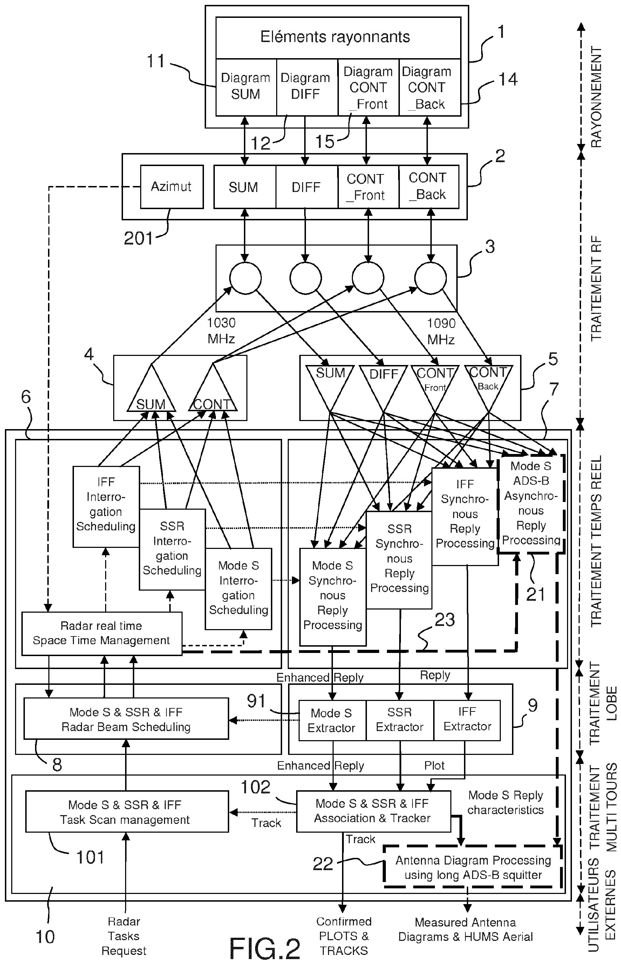

La figure 2 illustre la mise en œuvre matérielle de l'invention appliquée à un radar mode S ayant une antenne à quatre diagrammes. La figure présente le synoptique du radar de la figure 1 augmenté des éléments propres à l'invention. Les principaux éléments de l'invention appliqués au radar Mode S sont représentés en traits gras discontinus sur la figure 2.

Alors que le fonctionnement d'un radar Mode S est synchrone, on voit que les traitements ajoutés 21, 22 ne sont pas liés à l'émission et n'exploitent que la position en azimut de l'axe du lobe principal de l'antenne 23.

La plupart des éléments restent inchangés, vérifiant en cela à la fois :
- la non intrusion de l'invention dans le fonctionnement opérationnel du radar Mode S ;
- la mesure utilisant les mêmes éléments que ceux que le radar exploite via le même récepteur :
   - antenne ;
   - joint tournant ;
   - câbles de descente d'antenne.

Un premier traitement est ajouté 21 pour traiter la réception des squitters ADS-B. Il assure un traitement permanent des réponses asynchrones en Mode S (indépendamment des périodes d'écoutes associées aux interrogations), ce traitement 21 assure la détection et le décodage des réponses asynchrones en exploitant séparément mais également les quatre diagrammes d'antennes : SUM, DIFF, CONT_Front et CONT_Back pour :
- détecter toutes les réponses reçues, asynchrones et synchrones ;
- décoder les réponses pour en extraire l'adresse Mode S ;
- pour enrichir chaque réponse décodée de ses caractéristiques, notamment :
   - l'heure de détection ;
   - l'azimut du lobe principal de l'antenne lors de la détection ;
   - la puissance reçue dans les diagrammes SUM, DIFF, CONT_Front et CONT_Back ;
   - l'écartométrie de la réponse ADS-B c'est-à-dire la mesure du dépointage de la réponse vis-à-vis de l'axe de l'antenne.

A cet effet, la gestion spatio-temporelle 6 transmet la position en azimut 23 du lobe principal de l'antenne au traitement permanent 21 des réponses asynchrones Mode S.

On obtient en parallèle, avantageusement, un enrichissement des réponses synchrones par les puissances mesurées sur les diagrammes SUM, DIFF, CONT_Front et CONT_Back complétées par l'écartométrie.

Au niveau des extracteurs 9, on obtient également un enrichissement des plots Mode S de la puissance mesurée sur SUM.

Un deuxième élément ajouté 22 stocke et corrèle les données contenues dans les réponses squitters ADS-B longs (DF17) et les mesures des caractéristiques de ces réponses squitters par le radar. Il effectue notamment le calcul des 3 diagrammes d'antenne SUM, DIFF, CONT_Front et CONT_Back en élévation ainsi que l'erreur d'écartométrie en élévation en exploitant la position donnée dans les squitters ADS-B longs. Ce deuxième traitement est ajouté dans le traitement multi-tours où la position de la cible transmise dans le squitter avec l'adresse Mode S, heure et position complétées par les valeurs mesurées avec cette même réponse squitter de la puissance mesurée sur SUM, DIFF, CONT_Front et CONT_Back, écartométrie et azimut d'antenne.

Ce deuxième élément ajouté 22 met en œuvre le principe de l'invention qui consiste à exploiter le fait que les squitters ADS-B longs :
- sont par nature asynchrones entre la période des squitters ADS-B et la rotation du radar;
- étant reçus à tout moment, ils échantillonnent donc les diagrammes du faisceau principal de l'antenne à différents gisements ;
- étant émis par différentes cibles, ils échantillonnent les diagrammes du faisceau principal de l'antenne à différentes élévations, celles des cibles les ayant générées ;
- transmettent une mesure de position précise autre que celle du radar (position GPS du squitter long ADS-B) ;
- permettent d'effectuer la mesure de type radar sur le squitter même.

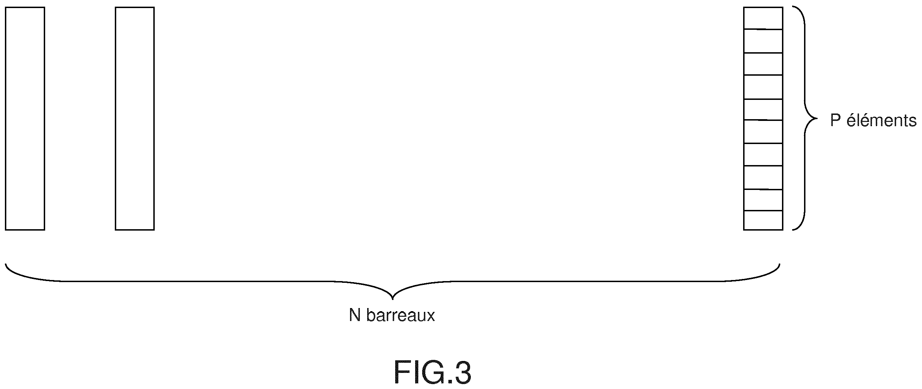

Avant de décrire plus en détail l'invention, on rappelle le principe de l'invention en regard de la représentation d'une antenne ATC d'un radar secondaire illustrée par la figure 3. Dans cet exemple, l'antenne est du type LVA. Elle comporte N barreaux, chaque barreau comportant P dipôles, par exemple 35 barreaux à 11 éléments chacun. L'invention exploite le contenu des messages DF17 qui précise la position (LAT-LONG) du transpondeur et la détection et mesure de la position de ce dernier par le radar. La répartition de l'énergie reçue entre les N barreaux permet la mesure de la position en azimut et la répartition de l'énergie reçue entre les dipôles de chaque barreau définit le diagramme en élévation.

Dans le but d'isoler une dégradation localisée au niveau soit du répartiteur entre les barreaux, soit au niveau d'un barreau, soit d'un dipôle d'un barreau, l'invention accumule les mesures par tranche d'élévation. C'est l'asynchronisme du squitter ADS-B long (DF17) et la disparité des cibles en altitude et distance (donc en élévation) qui permet de parcourir pratiquement la totalité du lobe d'antenne sur une période donnée (par exemple un jour).

Ainsi, comme cela sera décrit par la suite l'invention consiste notamment à mesurer le dépointage vis-à-vis de l'axe de l'antenne par tranche d'élévation des squitters ADS-B reçus par le radar dans son faisceau principal, mesurer l'erreur de la courbe d'écartométrie utilisée par le radar pour sa fonction écartométrie par différence entre la position donnée dans le squitter ADS-B et celle mesurée simultanément par écartométrie par le radar sur le même squitter ADS-B, puis à intégrer sur une période longue (quotidiennement par exemple) ces erreurs par tranche d'élévation.

De façon similaire, les mesures de la puissance dans chaque diagramme associées au squitter ADS-B permettent de calculer la puissance relative de SUM, DIFF et CONT_Front versus SUM_max pour le dépointage du squitter ADS-B dans le lobe, puis d'intégrer sur une période longue (quotidiennement) ces mesures par tranche d'élévation.

De cette façon, sans interférence avec le fonctionnement opérationnel du radar et sans balise, uniquement en utilisant des aéronefs équipés d'ADS-B d'opportunités, on peut automatiquement détecter une détérioration en cours notamment de la précision en azimut du radar indépendamment par tranche d'élévations ou plus globalement du faisceau principal du radar.

Le principe consiste à utiliser les Fruits (réponses asynchrones) que sont les squitters ADS-B longs reçus par le radar dans son faisceau principal correspondant aux cas d'un avion présent dans le lobe principal du radar au moment où il émet un squitter. En effet, de par sa mission première de localisation d'une cible, le squitter ADS-B long DF17 porte intrinsèquement la position Latitude-Longitude (LAT-LONG) de la cible.

Lors de sa réception, comme tout autre Fruit, le squitter ADS-B est enrichi des puissances reçues sur les différents diagrammes de l'antenne radar ainsi que de la valeur d'écartométrie mesurée comme pour toute réponse reçue dans le lobe du radar (cette valeur d'écartométrie n'ayant de sens que dans le faisceau principal plus précisément au voisinage de l'axe de l'antenne soit aux environs de 2,5° à +2,5° pour une antenne ATC de lobe à 3 dB de 2,4°). L'invention n'exploite que les squitters ADS-B validés par le radar c'est-à-dire à l'aide d'interrogations sélectives positivement répondues par la même cible au radar lors de sa tâche opérationnelle de surveillance de sa couverture aérienne de responsabilité évitant en cela la prise en compte de squitters ADS-B issus de spoofer dont la position déclarée peut-être fausse ou de cible dont le vol a montré des erreurs diverses avec les détections antérieures du radar.

L'invention exploite donc avantageusement les squitters ADS-B longs dont la position en gisement par rapport à l'axe de l'antenne les situe dans le faisceau principal (paramètre dépendant du type d'antenne ATC ou IFF) Pour chaque squitter ADS-B long, l'invention calcule donc :
- son gisement avec précision en exploitant la position LAT-LONG du squitter et celle LAT-LONG du radar donnant ainsi son dépointage dans le faisceau de l'antenne du radar ;
- sa puissance relative mesurée des diagrammes SUM, DIFF et CONT_Front versus SUM_max du plot synchrone quasi simultané du squitter par la même chaine de réception du radar (nécessaire pour la fonction détection du radar) ;
- sa tension d'écartométrie mesurée par la même chaine de réception du radar (nécessaire pour la fonction de localisation en azimut du radar) ;
- l'erreur avec les courbes théoriques de l'antenne :
   - selon l'élévation de la cible relativement à la position du radar ;
   - selon l'azimut du squitter ;
      ∘ en amplitude relative pour les diagrammes SUM, DIFF et CONT versus SUM_max ;
      ∘ en écartométrie en référence à la table d'écartométrie donnant sur la même réponse sans interférence avec le fonctionnement opérationnel du radar le dépointage mesuré de la cible fonction de la tension d'écartométrie de la réponse.

Il est à noter que pour étendre la plage de mesures et ainsi améliorer la précision de ce monitoring des diagrammes du faisceau principal, l'invention effectue un calcul par tranche d'élévations afin de tenir compte des effets d'évasement des diagrammes de l'antenne (donc notamment de la fonction d'écartométrie) en cosinus de l'élévation de la cible par rapport au radar.

Pour garantir une bonne précision des mesures élémentaires on exploite par exemple :
- les squitters de fort niveau (à courte portée) afin de limiter l'effet du bruit du récepteur tout en assurant une dynamique suffisante pour la mesure des faisceaux SUM, DIFF et CONT_Front ;
- les squitters de cible à courte et moyenne portée (selon l'élévation) pour optimiser la mesure d'erreur d'écartométrie en minimisant l'influence de la précision de position de la cible transmise par celle-ci lors de la détection du squitter ADS-B (latence variable entre la position GPS mesurée du squitter et l'heure de réception du squitter par le radar).

L'accumulation de ces mesures pendant une durée importante permet de couvrir toutes les valeurs d'élévations, d'azimuts et de gisements qu'exploite le radar et ainsi d'améliorer la précision des calculs d'erreurs selon les 3 axes retenus. De plus, l'accumulation de ces erreurs (écartométrie et amplitude fonction du gisement) par tranche d'azimut (au pas du degré par exemple) permet de faire apparaitre des singularités liées à un azimut donné. Ces erreurs sont analysées (par des moyens automatiques par exemple). Si le résultat d'analyse estime un nombre d'erreurs trop important (en amplitude comme en écartométrie) on peut émettre des hypothèses de source de la dégradation :
- si elle ne dépend pas de l'azimut du squitter ni du gisement ni de l'élévation :
   - il peut s'agir d'une détérioration des câbles de descente d'antenne ;
- si elle dépend de l'azimut du squitter mais pas du gisement ni de l'élévation :
   - il peut s'agir d'une détérioration du joint tournant associant partie fixe et partie rotative de l'antenne du radar ;
- si elle dépend du gisement mais pas de l'azimut du squitter ni de l'élévation :
   - il peut s'agir d'une détérioration d'un dipôle vertical de l'antenne ou du répartiteur de l'antenne ;
- si elle dépend du gisement et de l'élévation mais pas de l'azimut du squitter :
   - il peut s'agir d'une détérioration d'un élément rayonnant d'un dipôle vertical de l'antenne.

D'autres hypothèses de sources de dégradation peuvent être émises.

Ainsi, une analyse permanente de ces mesures permet d'alerter automatiquement afin de prévoir si nécessaire une opération de réparation pouvant être programmée avant que les performances du radar se dégradent dans une approche de type HUMS (« Health and Usage Monitoring Systems »).

En ce qui concerne le décodage des réponses « squitter ADS-B long », le Chapitre 3 de l'Annexe 10 - Télécommunications aéronautiques - donne le récapitulatif des formats de réponse (descendants) mode S
Les squitters ADS-B longs (DF17 et DF18) sont bien d'un format de message identique aux réponses synchrones que traite un radar. Ainsi, l'emploi d'un traitement similaire aux réponses asynchrones comme aux réponses synchrones permet d'obtenir des mesures de diagrammes identiques selon les deux natures de messages et ainsi de pouvoir en déduire des conclusions communes à savoir qu'une dégradation de l'antenne mesurée par les réponses asynchrones est complètement applicable aux réponses synchrones.

La détection des réponses par un radar selon l'invention diffère selon que ces réponses sont synchrones ou asynchrones comme le tableau 1 ci-dessous le résume selon les diagrammes de l'antenne, les données numériques étant données à titre d'exemple :

| | **Unité LSB** | **Réponse Synchrone** | **Réponse Asynchrone** | |
|---|---|---|---|---|
| | | Lobe Principal | Lobe Principal | Hors Lobe Principal |
| Heure de Détection | ms | Oui | Oui | Oui |
| Adresse Mode S | | Oui | Oui | Oui |
| Azimut Antenne | ACP14 | Oui | Oui | Oui |
| Off Boresight Angle_OBA | ACP14 | Oui | Oui | Non |
| Azimut cible | ACP14 | Oui | Oui | Non |
| Distance cible | 50ns | Oui | Non | Non |
| Elevation cible | | Oui | Non | Non |
| Protocol Secondaire | | IFF/SSR | ModeS | ModeS |
| DF Format | | Oui | Oui | Oui |
| Data Mode S | | Oui | Oui | Oui |
| Puissance SUM | 0,1 dBm | Oui | Oui | Oui |
| Puissance DIFF | 0,1 dBm | Oui | Oui | Oui |
| Puissance CONT_Front | 0,1 dBm | Oui | Oui | Oui / Non |
| Puissance CONT_Back | 0,1 dBm | Non | Non | Oui / Non |

Selon l'invention toutes les réponses asynchrones sont enrichies de la puissance mesurée selon chaque diagramme.

Les différentes réponses mode S, synchrones comme asynchrones, sont très similaires en ce qui concerne l'adresse mode S :
- soit dans le champ parité ;
- soit dans le champ data.

L'adresse mode S est un identifiant unique du transpondeur et permet donc en traitement asynchrone comme classiquement en traitement synchrone d'identifier une cible et de s'assurer par une interrogation sélective du radar que le squitter ADS-B est bien une cible réelle dans la couverture du radar. L'invention ne pas prend pas en compte les squitters ADS-B considérés comme douteux c'est-à-dire non validés par les interrogations sélectives du radar.

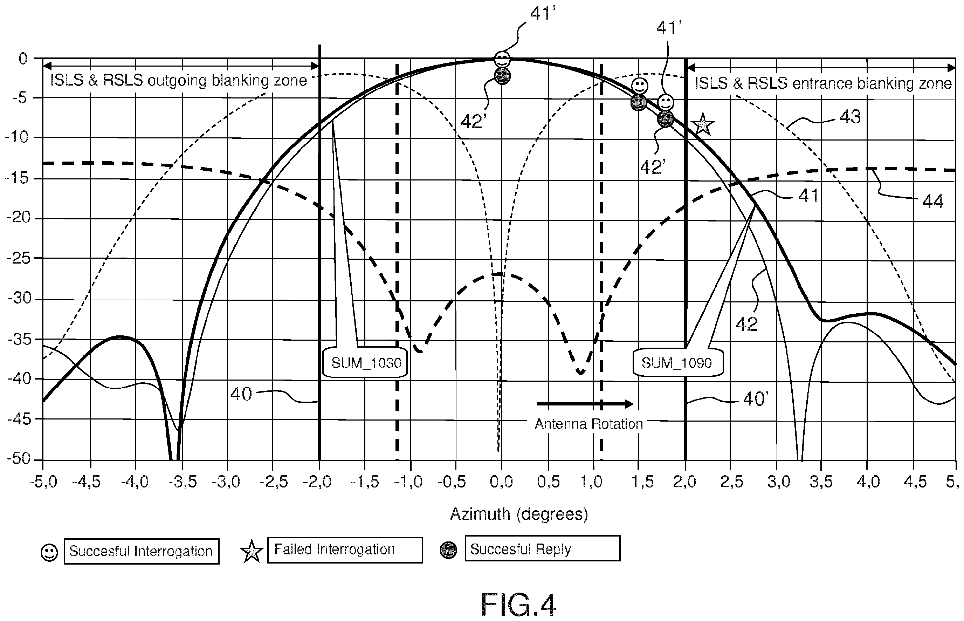

La figure 4 illustre par un exemple le fonctionnement synchrone typique d'un radar secondaire exploitant le faisceau principal à la fois en émission et en réception d'une antenne ATC classique avec trois diagrammes (SUM, DIFF, CONT_Front), à l'intérieur d'une zone azimutale encadrée par deux limites 40 (à ≈-2°), 40' (à ≈+2°) :
- SUM pour :
   - la génération des interrogations vers le transpondeur (courbe 41) avec les interrogations 41' ;
   - la détection des réponses du transpondeur (courbe 42) avec les réponses 42' ;
- DIFF pour :
   - la localisation des réponses vis-à-vis de l'axe de l'antenne (courbe 43) ;
   - pour certains types de radar, la discrimination de réponses emmêlées ;
- CONT_Front pour la délimitation des réponses à traiter dans le faisceau de l'antenne (courbe 44) :
   - ISLS : Bloquer à l'émission (1030MHz) les transpondeurs en dehors du cœur du faisceau principal (voir l'étoile sur la figure 4 correspondant à une interrogation refusée par le transpondeur) ;
   - RSLS : Réjecter à la réception (1090MHz) les réponses en dehors du cœur du faisceau principal.

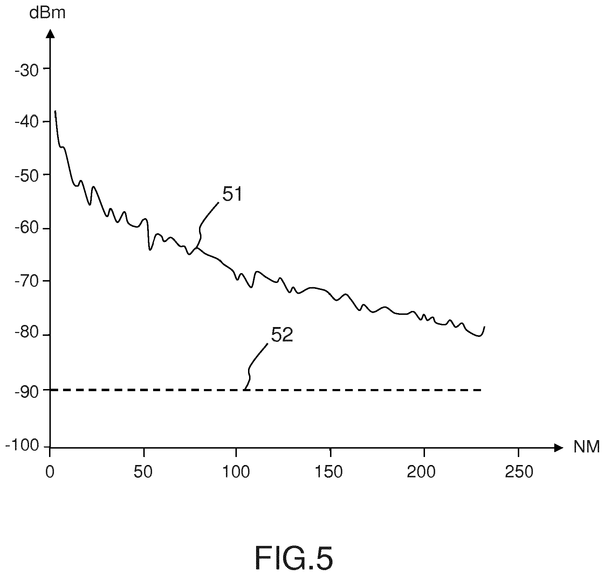

La figure 5 illustre la puissance reçue en fonction de la distance de la cible. Les courbes de la figure 4 représentatives des diagrammes de l'antenne montrent que la dynamique de puissance des signaux à traiter, dans le faisceau principal, est de l'ordre de 25 dB à 35 dB en relatif entre les diagrammes. La courbe 51 indique la puissance moyenne par cible reçue (c'est-à-dire par plot) en fonction de la distance de la cible. Cette courbe 51, typique du bilan radar descendant, permet d'évaluer la puissance du signal reçue d'une cible. Pour garantir une bonne dynamique et précision, le procédé selon l'invention n'utilise que les cibles proches dont le niveau de puissance est au moins 35 dB au-dessus du seuil 52 de détection et de décodage des réponses ADS-B par le radar. Etant donné que les squitters ADS-B longs pris en considération pour l'invention sont ceux reçus dans le faisceau principal du radar, leur niveau est proche de celui de la même cible quand elle répond en mode synchrone au radar. En pratique, cela conduit par exemple à n'utiliser pour la mesure des diagrammes que les squitters ADS-B longs dont la cible est dans les 50 Nm du radar, cette valeur pouvant être ajustée par paramètre par un opérateur.

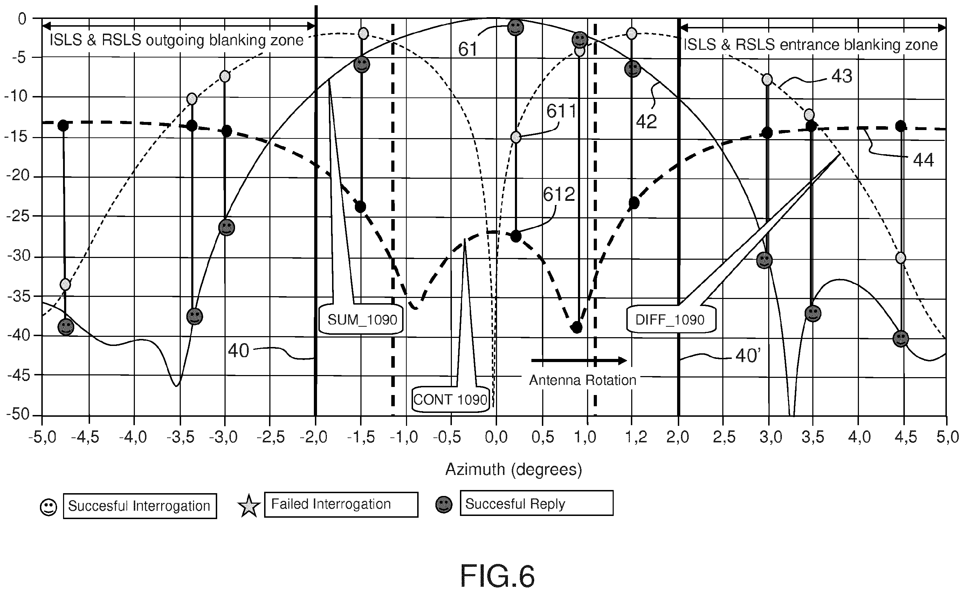

La figure 6 illustre le principe de l'invention par un exemple d'échantillonnage des diagrammes de l'antenne en réception à 1090MHz par une dizaine de squitters émis par différentes cibles. Les diagrammes sont les mêmes que ceux de la figure 4 décrits dans le cas d'une utilisation synchrone, seul le diagramme d'interrogation 41 ayant été supprimé. L'invention exploite avantageusement les squitters longs ADS-B pour mesurer avec grande précision, en permanence, les diagrammes du faisceau principal des antennes du radar secondaire, avec des cibles d'opportunité selon différentes élévations choisies en distance selon le type de mesure effectuée.

Lorsque le faisceau principal du radar éclaire des cibles, celles-ci sont interrogées sélectivement par le radar comme le montre la figure 4, et peuvent émettre automatiquement des squitters sur leur propre rythme dont les ADS-B longs comme l'illustre la figure 6.

Cette figure montre une antenne ATC ou IFF typique de 3 diagrammes : SUM, DIFF et CONT_Front, représentés respectivement par les courbes 42, 43, 44.

A un instant donné les différentes cibles, présentes dans un azimut de -5° à +5° de l'axe de l'antenne, peuvent émettre des squitters longs 61. Chaque squitter détecté dans le lobe est enrichit de :
- ses niveaux reçus sur les 3 diagrammes 42, 43, 44 - ainsi un squitter est reçu à niveau 61 sur le diagramme SUM 42, à un niveau 611 sur le diagramme DIFF 43 et à un niveau 612 sur le diagramme CONT_Front 44 ;
- sa tension d'écartométrie calculée par le radar à partir des signaux de la réponse reçue sur DIFF et SUM ;
- son gisement versus l'axe de l'antenne (axe des abscisses X).

Selon la distance de la cible, la dynamique du signal (axe des ordonnées Y), donnée par le niveau reçu versus le seuil de mesure du radar, permet d'avoir la dynamique requise (voisine de 35dB).

Chaque squitter étant caractérisé par l'adresse mode S de la cible :
- certains squitters donnent la position LAT-LONG de la cible ;
- d'autres donnent l'altitude de la cible (barométrique ou GNSS).

L'asynchronisme entre :
- la position des cibles en azimut et élévation ;
- la rotation du faisceau du radar ;
- l'émission spontanée des squitters ADS-B longs par les cibles ;
permet tout au long de la rotation de l'antenne du radar sur une longue durée d'échantillonner toutes les positions possibles :
- en gisement ;
- en élévation (déduite de la position LAT-LONG donnant la distance et l'altitude de la cible) ;
- en azimut de l'axe du faisceau d'antenne.

L'accumulation des mesures issues des squitters ADS-B est par ailleurs effectuée. A cet effet, l'invention piste tous les squitters ADS-B longs (asynchrones) afin de construire des pistes ADS-B, de façon analogue aux pistes synchrones du radar. Ces pistes se caractérisent principalement par :
- l'adresse mode S ;
- la position courante de la cible et son vecteur vitesse en 3D (azimut, distance, altitude) ;
- la puissance courante de la cible ;
- l'utilisation possible de cette piste par le procédé selon l'invention.

Même si un squitter d'une cible n'est pas reçu dans le faisceau principal de l'antenne, il est pisté afin d'enrichir la piste des données citées ci-avant.

En effet, selon la valeur du TC, un squitter ADS-B long DF17 comporte une donnée, notamment la position LAT-LONG et l'altitude.

Pour chaque squitter utilisable (validé par le radar) reçu dans le faisceau principal (dépointé par exemple d'au plus -10° à 10° en gisement de l'axe de l'antenne lors de sa détection, sachant que cette plage angulaire n'est pas limitative, l'invention pouvant s'appliquer sur -180° à 180°), le procédé selon l'invention :
- exploite l'information contenue dans le squitter ;
- complète l'information manquante à partir des données de sa piste ;
- calcule la puissance relative puis l'erreur du gain des diagrammes de l'antenne en fonction du gisement :
   - dans le même faisceau le radar mesure la puissance du plot synchrone (voir la figure 4) : c'est la valeur SUM_max (en dBm) pouvant être obtenue par cette configuration radar à cette distance de la cible ;
   - la réponse du squitter ADS-B long est enrichie d'une mesure de puissance (en dBm) sur les diagrammes SUM, DIFF et CONT, le procédé selon l'invention déduisant pour le gisement du squitter :
      ∘ SUM-relative (dB) = SUM (en dBm) - SUM_max (en dBm) ;
      ∘ DIFF-relative (dB) = DIFF (en dBm) - SUM_max (en dBm) ;
      ∘ CONT-relative (dB) = CONT (en dBm) - SUM_max (en dBm) ; SUM-relative (dB), SUM (en dBm) et SUM_max (en dBm) sont définis comme suit : les courbes en figure 4 (ou en figure 6) représentent les gains relatifs (en dB), par rapport à la puissance maximum SUM max dans l'axe de l'antenne, des diagrammes d'antenne de SUM, DIFF, CONT, selon le dépointage en gisement de l'axe de l'antenne. Quand une réponse ADS-B est reçue avec un certain dépointage la mesure de puissance (en dBm) est effectuée selon les trois diagrammes.

DIFF-relative (dB) et DIFF (en dBm), CONT-relative (dB) et CONT (en dBm) sont définies de façon analogues pour les diagrammes DIFF et CONT.

En comparant la puissance du plot synchrone le plus proche temporellement du fruit ADS-B appelé ici SUM_max en dBm, à celle de l'ADS-B sur les trois diagrammes on obtient les points de la courbe 42" (SUM), de la courbe 43"

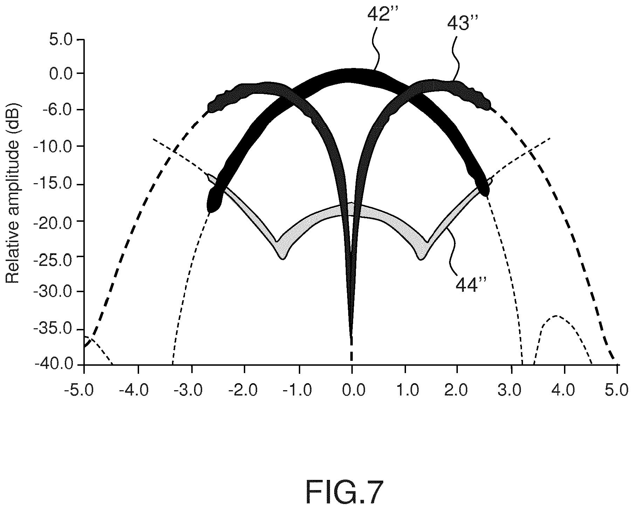

(DIFF) et de la courbe 44" (CONT) du gain relatif selon le dépointage présentées en figure 7 qui sera décrite par la suite.
- L'erreur de gain de chaque diagramme est établie en comparant ces valeurs à celles de référence de l'invention (diagrammes mesurées soit lors de la recette du radar en usine, soit lors de l'acceptation du site radar) :
   ∘ SUM_err (dB) = SUM-relative (dB) - SUM-reference (dB) ;
   ∘ DIFF_err (dB) = DIFF-relative (dB) - DIFF-reference (dB) ;
   ∘ CONT_err (dB) = CONT-relative (dB) - CONT-reference (dB) ;
- pour le lobe principal, l'erreur d'écartométrie est établie en comparant la position mesurée par le radar à celle transmise dans le squitter ADS-B pour le dépointage de celle-ci dans le faisceau en tenant compte de la déformation du faisceau en élévation relative à l'antenne.

Pendant la durée de l'analyse, ces différentes valeurs sont accumulées en fonction du gisement au fur et à mesure selon :
- l'azimut de l'antenne (au pas par exemple du degré) ;
- mais aussi quel que soit l'azimut ;
- l'élévation de la cible.

L'utilisation de squitter ADS-B auto porteur en position détecté dans le lobe principal présente 2 avantages majeurs :
- pour la mesure des diagrammes dans le faisceau principal (de -10° à +10° de l'axe), suite à la réception quasi simultanée du squitter ADS-B et du plot synchrone, la puissance émise par la cible est alors constante tant pour les réponses synchrones du plot que la réponse asynchrone du squitter permettant d'avoir une mesure relative très précise des 3 diagrammes SUM, DIFF, CONT ;
- pour le « monitoring » de la précision azimut du radar, la mesure selon la méthode radar de la position azimut de la cible ayant émis le squitter ADS-B directement à partir de la réponse ADS-B permet d'avoir une mesure d'erreur d'écartométrie très précise puisque la cible n'a pas évoluée entre la position transmise et celle mesurée.

La figure 7 illustre l'accumulation de ces valeurs qui permet de reconstituer le diagramme SUM (diagramme mesuré 42"), le diagramme DIFF (diagramme mesuré 43") et le diagramme CONT (diagramme mesuré 44"), entre -5° et +5°. Dans cet exemple, les parties en gras des diagrammes SUM, DIFF, CONT sont obtenues avec environ 18000 réponses.

Les tracés d'acceptation usine sont faits classiquement avec un pas en gisement égal à environ 0,05°.

Afin d'avoir une précision de cet ordre, la durée de l'analyse doit être suffisamment grande (de l'ordre d'un jour par exemple) dans le but d'avoir assez d'échantillons dans chaque cellule (azimut, élévation, gisement). En effet, ce sont les cibles en fonction de leur position relative au radar dans le site considéré qui échantillonnent les diagrammes de l'antenne donc seule la durée de l'analyse permet de recueillir assez de mesures.

Il est à noter que les chiffres donnés ici ne sont donnés que comme indication d'un ordre de grandeur, en effet ils peuvent être paramétrés par un opérateur en fonction notamment de ses besoins en précision, en taux de renouvellement et selon le taux de fruits disponibles d'avions proches du radar.

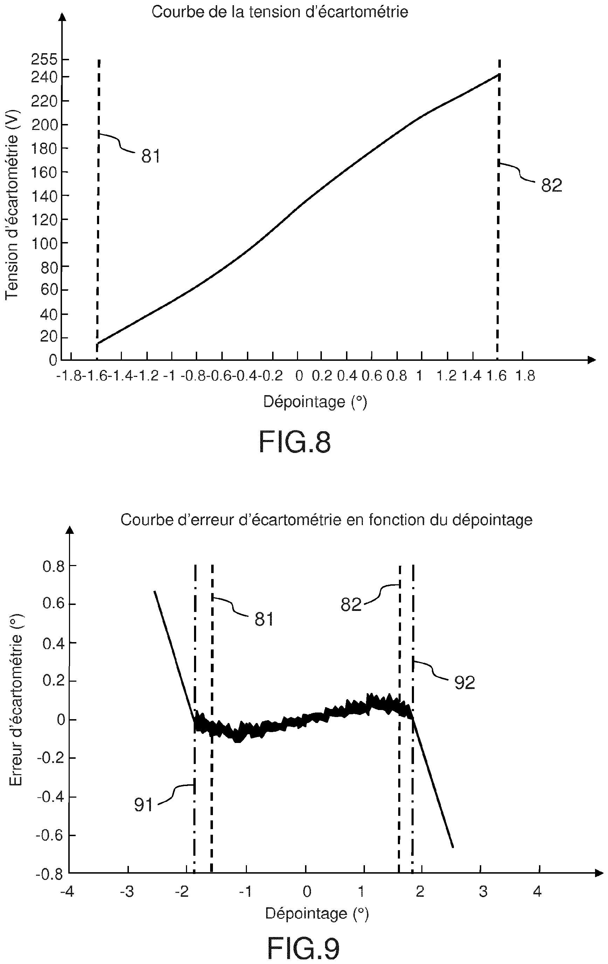

La figure 8 présente un zoom sur la partie utile de la courbe de la tension d'écartométrie en fonction du dépointage dans le lobe principal. Cette courbe est stockée inversée dans la table d'écartométrie laquelle est utilisée par le radar, en fonction de la mesure du rapport DIFF/SUM d'une réponse synchrone ou asynchrone reçue dans le lobe principal, pour évaluer le dépointage de celle-ci vis-à-vis de l'axe de l'antenne.

Les traits pointillés verticaux 81, 82 délimitent la zone utile de la courbe qu'exploite classiquement un radar associé à une antenne LVA de 2,4° à -3dB.

La figure 9 présente le tracé de la courbe d'erreur en azimut sur un grand nombre de réponses (plus de 8000) en fonction du dépointage de la cible dans le lobe principal. On note que celle-ci commence à montrer une légère pente avec des erreurs de près de +/-0,1° en bord de lobe à comparer avec la précision azimut attendue d'un radar en standard déviation de 0,08°. Telle que définie en exemple dans ce radar, la table d'écartométrie est limitée à la plage comprise entre les traits pointillés 91, 92, en cohérence il est normal que l'erreur croisse beaucoup en dehors de cette zone non exploitée par le radar en exemple.

L'invention établit un gabarit des différents diagrammes d'antenne SUM, DIFF, CONT et d'erreur d'écartométrie en fonction des tracés usine de l'antenne (lors de l'acceptation usine) équipant le site radar.

Suite au calcul des diagrammes d'antenne et d'erreur d'écartométrie, typiquement chaque jour, le procédé selon l'invention compare les mesures effectuées au gabarit et produit une synthèse des points hors du gabarit pondérant celle-ci en considérant la quantité et la qualité des fruits utilisés pour mesurer les diagrammes et l'écartométrie.

Cette synthèse HUMS, typiquement journalière, permet d'évaluer une potentielle dégradation en cours de l'antenne (incluant câble et joint tournant).

De plus, en ayant établie la déformation caractéristique des diagrammes d'antenne et la déformation de la courbe d'écartométrie en fonction de différents type de dégradation de partie spécifique de l'aérien, l'invention propose des éléments de dégradation :
- perte de niveau uniforme des diagrammes SUM, DIFF et/ou CONT quel que soit l'azimut, le gisement et l'élévation ;
   - augmentation des pertes des câbles RF de xdB ;
- perte de précision azimut quels que soient l'azimut, le gisement et l'élévation ;
   - augmentation des pertes du câble RF de SUM ou de DIFF de xdB ;
- perte de précision azimut à certains azimuts quels que soient le gisement et l'élévation ;
   - dégradation du joint tournant en amplitude de XX ou en phase de YY à un/des azimuts donnés ;
- déformation des diagrammes à certains gisements quels que soient l'azimut et l'élévation ;
   - dégradation d'une colonne de rayonnement ou au niveau du répartiteur de l'antenne.

D'autres signes de dégradation pouvant encore être obtenus.

Cette analyse permanente des trois diagrammes d'antenne et de l'écartométrie est effectuée vis-à-vis de plusieurs gabarits. Elle permet de quantifier au niveau fonctionnel une dégradation des performances pouvant à terme déclarer le radar ou le récepteur ADS-B utilisant le même aérien comme dégradé voir en panne.

Au-delà des gabarits usuels pour garantir la performance, des gabarits dédiés peuvent être définis dans le but de détecter des dégradations usuelles de l'aérien auxquelles auront été associées les déformations des diagrammes d'antennes consécutifs à ces dégradations.

Enfin, le suivi de l'évolution de jour en jour des dégradations permet de planifier une date limite d'intervention sur le site radar avant que celles-ci influent sur les performances du radar de manière à rendre celui-ci non opérationnel.

De plus, un avantage supplémentaire de l'invention est le suivant : l'établissement de l'erreur de la fonction d'écartométrie, journalièrement par exemple, permet, lorsque celle-ci reste dans un gabarit de tolérance encore acceptable par un opérateur, de corriger la table d'écartométrie qu'emploie le radar pour localiser les cibles synchrones en azimut dans le faisceau et ainsi d'assurer toujours une bonne précision azimutale du radar lors du début d'une dégradation de l'aérien ou d'un vieillissement de l'aérien. L'aérien étant l'ensemble composé au moins de l'antenne 1, des câbles de descente d'antenne et du joint tournant.

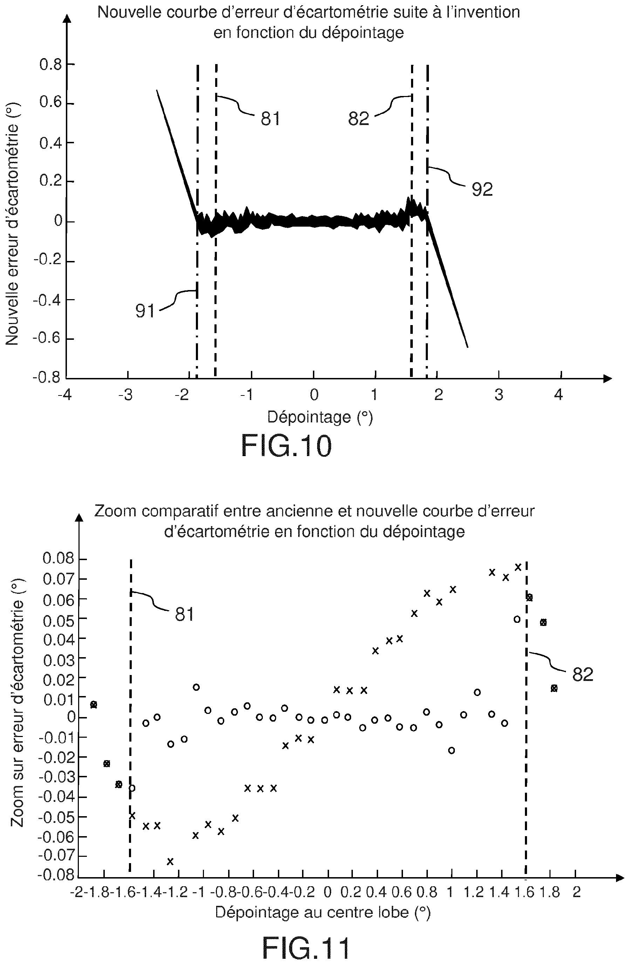

La figure 10 présente le tracé de la nouvelle courbe d'erreur en azimut selon l'invention après calcul de la nouvelle table d'écartométrie sur le même grand nombre de réponses (plus de 8000) en fonction du dépointage de la cible dans le lobe principal. On note que celle-ci est quasi plate présentant des erreurs toutes nettement inférieures à +/-0,05°crête à crête.

La figure 11 présente un zoom sur la partie utile du lobe en comparant les tracés des courbes d'erreur en azimut en fonction du dépointage de la cible, en employant soit la table d'écartométrie ancienne soit la nouvelle selon l'invention sur le même grand nombre de réponses (plus de 8000).

On y note directement le gain en précision azimut du radar selon le dépointage de la réponse synchrone : avec la nouvelle courbe d'écartométrie, l'erreur azimut est très faible et quasi constante quelle que soit la position de la cible dans le lobe.

## Revendications

1. Procédé de mesure des diagrammes d'antenne (1) et d'écartométrie par tranches d'élévation d'un radar secondaire, chaque diagramme (11, 12, 14, 15) étant associé à une voie de réception (5), **caractérisé en ce que**, sur une période de temps donnée,
- on détecte les réponses asynchrones non sollicitées (61), de type squitters ADS-B longs, émises par des cibles présentes dans l'environnement aérien dudit radar, chacun desdits squitters contenant une information de position 3 D de la cible qui l'émet ;
- pour chaque détection, on décode le squitter ADS-B longs pour vérifier que la cible détectée est localisée conformément à l'information de position contenue dans ledit squitter, les détections non conformes étant rejetées ;
- pour chaque détection retenue, l'heure de ladite détection, la valeur de l'azimut de l'axe du faisceau principal de ladite antenne, la tension d'écartométrie et la valeur de puissance reçue (61, 611, 612) sur chacune desdites voies de réception SUM, DIFF, CONT_Front, CONT_Back sont associées à ladite détection, l'information de position contenue dans ledit squitter donnant par calcul la tranche d'élévation dans laquelle est située ladite détection ;
lesdites valeurs obtenues sur ladite période étant mémorisées, les diagrammes mesurés (42", 43", 44") et les mesures d'écartométrie étant échantillonnés, par tranche d'élévation, à partir desdites valeurs mémorisées.

2. Procédé selon la revendication 1, **caractérisé en ce que** ladite antenne comporte un des ensembles de diagrammes suivant :
- un diagramme somme (SUM), un diagramme différence (DIFF), un diagramme de contrôle pour rejeter des réponses de cibles face à l'antenne (CONT_Front) et un diagramme de contrôle pour rejeter des cibles à l'arrière de l'antenne (CONT_Back) ;
- un diagramme somme (SUM), un diagramme différence (DIFF), un diagramme de contrôle (CONT) ;
- un diagramme somme (SUM) et un diagramme différence et contrôle (DIFF/CONT).

3. Procédé selon l'une quelconque des revendications 1 ou 2, **caractérisé en ce que** les réponses de type squitters ADS-B longs sont enrichies par des caractéristiques représentatives de l'acquisition desdites réponses, lesdites caractéristiques étant pour chaque réponse au moins l'une des caractéristiques suivantes :
- la puissance reçue selon chaque diagramme de ladite antenne ;
- l'écartométrie de la réponse dans le lobe principal de la dite antenne ;
- l'heure de la détection de ladite réponse ;
- l'azimut de l'axe du faisceau principal de ladite antenne lors de ladite détection.

4. Procédé selon la revendication 3, **caractérisé en ce que**, pour chaque squitter reçu dans le faisceau principal, ledit procédé :
- exploite l'information contenue dans le squitter ;
- calcule la puissance relative puis l'erreur du gain des diagrammes de l'antenne en fonction du gisement :
• dans le même faisceau, ledit radar mesurant la puissance du plot synchrone, ladite puissance étant la valeur maximum du diagramme somme ;
• la réponse squitter ADS-B long étant enrichie d'une mesure de puissance sur les diagrammes somme, différence et contrôle, le procédé selon l'invention déduisant pour le gisement du squitter :
∘ SUM-relative (dB) = SUM (en dBm) - SUM_max (en dBm) ;
∘ DIFF-relative (dB) = DIFF (en dBm) - SUM_max (en dBm) ;
∘ CONT-relative (dB) = CONT (en dBm) - SUM_max (en dBm) ;
• l'erreur de gain de chaque diagramme est établie en comparant ces valeurs à celles de référence de l'invention (diagrammes mesurées soit lors de la recette du radar en usine, soit lors de l'acceptation du site radar) :
∘ SUM_err (dB) = SUM-relative (dB) - SUM-reference (dB) ;
∘ DIFF_err (dB) = DIFF-relative (dB) - DIFF-reference (dB) ;
∘ CONT_err (dB) = CONT-relative (dB) - CONT-reference (dB) ;
- calcule l'erreur d'écartométrie en tenant compte de la déformation du faisceau en élévation relative à l'antenne.

5. Procédé selon l'une quelconque des revendications précédentes, **caractérisé en ce que** pendant la durée de l'analyse, lesdites valeurs sont accumulées en fonction du gisement au fur et à mesure selon :
- l'azimut de ladite antenne ;
- l'élévation de ladite cible.

6. Procédé selon l'une quelconque des revendications précédentes, **caractérisé en ce que** sur ladite période donnée, on accumule dans des tables à trois entrées l'erreur d'écartométrie et l'erreur de chaque diagrammes, une table étant associée à l'erreur d'écartométrie et à l'erreur de chaque diagramme d'antenne, une entrée étant le gisement en fonction de l'axe du lobe principal de l'antenne, la seconde entrée étant l'élévation de la cible en fonction de l'horizontalité de l'antenne et la troisième entrée étant l'azimut antenne.

7. Procédé selon la revendication 6, **caractérisé en ce que** pour chaque cellule (gisement, élévation) de ladite table, l'erreur d'écartométrie et l'erreur de chaque diagramme sont établies par des méthodes du type moyenne, histogramme ou autres.

8. Procédé selon l'une quelconque des revendications précédentes, **caractérisé en ce que** ladite période donnée est définie pour laisser apparaître des dégradations en cours desdits diagrammes.

9. Procédé selon l'une quelconque des revendications précédentes, **caractérisé en ce que**, sous contrôle d'un opérateur ou automatiquement, ledit radar employant une table d'écartométrie pour localiser les cibles synchrones en azimut dans ledit faisceau principal, ladite table est corrigée sur la base des erreurs d'écartométrie mesurées afin d'assurer une bonne précision azimutale dudit radar lors d'une dégradation de l'ensemble de composants dit aérien.

10. Procédé selon l'une quelconque des revendications précédentes, **caractérisé en ce que** l'antenne, équipant un radar secondaire du type ATC ou IFF, comporte au moins deux diagrammes.

11. Procédé selon l'une quelconque des revendications précédentes, caractérisé en ce ladite antenne (1) est à balayage électronique, fixe ou tournante.

12. Procédé selon l'une quelconque des revendications précédentes, **caractérisé en ce que** les mesures de l'erreur d'écartométrie et des diagrammes d'antenne sont utilisées pour évaluer le niveau de dégradation de chaque élément de l'aérien : antenne, câbles de la descente d'antenne, joint tournant.

13. Procédé selon l'une quelconque des revendications précédentes, caractérisé en ce la mesure desdits diagrammes est utilisée pour évaluer le niveau de dégradation de l'ensemble de composants dit aérien.

14. Radar secondaire, **caractérisé en ce qu'**il est apte à mettre en œuvre le procédé selon l'une quelconque des revendications précédentes.

## Patentansprüche

1. Verfahren zur Messung von Antennendiagrammen und zur Winkelabweichungsmessung (1) über Elevationsabschnitte eines Sekundärradars, wobei jedes Diagramm (11, 12, 14, 15) einem Empfangskanal (5) zugeordnet ist, **dadurch gekennzeichnet, dass** über einen vorgegebenen Zeitraum,
- die nicht geforderten asynchronen Antworten (61) vom langen ADS-B-Squitter-Typ erkannt werden, die von in der Luftumgebung des Radars vorliegenden Zielen ausgestrahlt werden, wobei jedes der Squitter eine 3D-Positionsinformation des Ziels, das es ausstrahlt, enthält;
- für jede Detektion das lange ADS-B-Squitter decodiert wird, um zu überprüfen, ob das erkannte Ziel entsprechend der in dem Squitter enthaltenen Positionsinformation lokalisiert wurde, wobei die nicht entsprechenden Detektionen verworfen werden;
- für jede behaltene Detektion die Uhrzeit der Detektion, der Azimutwert der Hauptstrahlachse der Antenne, die Spannung der Winkelabweichungsmessung und der empfangene Leistungswert (61, 611, 612) in jedem der Empfangskanäle SUM, DIFF, CONT_Front, CONT_Back der Detektion zugeordnet werden, wobei die in dem Squitter enthaltene Positionsinformation durch Berechnung den Elevationsabschnitt, in dem sich die Detektion befindet, ergibt;
wobei die über den Zeitraum erhaltenen Werte gespeichert werden, die gemessenen Diagramme (42", 43", 44") und die Winkelabweichungssmessungen pro Elevationsabschnitt anhand der gespeicherten Werte gesampelt werden.

2. Verfahren nach Anspruch 1, **dadurch gekennzeichnet, dass** die Antenne eine der folgenden Diagrammgruppen aufweist:
- ein Summendiagramm (SUM), ein Differenzdiagramm (DIFF), ein Kontrolldiagramm zum Verwerfen von Zielantworten gegenüber der Antenne (CONT_Front) und ein Kontrolldiagramm zum Verwerfen von Zielen hinter der Antenne (CONT_Back);
- ein Summendiagramm (SUM), ein Differenzdiagramm (DIFF), ein Kontrolldiagramm (CONT);
- ein Summendiagramm (SUM) und ein Differenz- und Kontrolldiagramm (DIFF/CONT).

3. Verfahren nach einem der Ansprüche 1 oder 2, **dadurch gekennzeichnet, dass** die Antworten vom langen ADS-B-Squitter-Typ durch Kennzeichen angereichert werden, die für die Erfassung der Antworten repräsentativ sind, wobei die Kennzeichen für jede Antwort mindestens eines der folgenden Kennzeichen sind:
- die gemäß jedem Diagramm der Antenne empfangene Leistung;
- die Winkelabweichungsmessung der Antwort in der Hauptkeule der Antenne;
- die Uhrzeit der Detektion der Antwort;
- der Azimut der Hauptstrahlachse der Antenne bei der Detektion.

4. Verfahren nach Anspruch 3, **dadurch gekennzeichnet, dass** für jedes in dem Hauptstrahl empfangende Squitter das Verfahren:
- die in dem Squitter enthaltene Information auswertet;
- die relative Leistung und dann den Verstärkungsfehler der Diagramme der Antenne in Abhängigkeit von dem Peilwinkel berechnet:
• wobei im gleichen Strahl der Radar die Synchronleistung des Plots misst, wobei die Leistung der Höchstwert des Summendiagramms ist;
• wobei die Antwort des langen ADS-B-Squitters durch eine Leistungsmessung an dem Summen-, Differenz- und Kontrolldiagramm angereichert wird, wobei das Verfahren nach der Erfindung für den Peilwinkel des Squitter Folgendes herleitet:
∘ SUM-relative (dB) = SUM (en dBm) - SUM_max (en dBm);
∘ DIFF-relative (dB) = DIFF (en dBm) - SUM_max (en dBm);
∘ CONT-relative (dB) = CONT (en dBm) - SUM_max (en dBm) ;
• wobei der Verstärkungsfehler jedes Diagramms durch Vergleichen dieser Werte mit den Referenzwerten der Erfindung bestimmt wird (Diagramme, die entweder bei Empfang des Radars in der Anlage oder bei Annahme des Radarstandorts gemessen werden):
∘ SUM_err (dB) = SUM-relative (dB) - SUM-reference (dB);
∘ DIFF_err (dB) = DIFF-relative (dB) - DIFF-reference (dB);
∘ CONT_err (dB) = CONT-relative (dB) - CONT-reference (dB);
- den Fehler der Winkelabweichungsmessung unter Berücksichtigung der Elevationsverformung des Strahls relativ zur Antenne berechnet.

5. Verfahren nach einem der vorhergehenden Ansprüche,
**dadurch gekennzeichnet, dass** während der Dauer der Analyse die Werte in Abhängigkeit von dem Peilwinkel nach und nach akkumuliert werden gemäß:
- dem Azimut der Antenne;
- der Elevation des Ziels.

6. Verfahren nach einem der vorhergehenden Ansprüche,
**dadurch gekennzeichnet, dass** über den gegebenen Zeitraum in Tabellen mit drei Einträgen der Fehler der Winkelabweichungsmessung und der Fehler aller Diagramme akkumuliert werden, wobei eine Tabelle dem Fehler der Winkelabweichungsmessung und dem Fehler jedes Antennendiagramms zugeordnet ist, ein Eintrag der Peilwinkel in Abhängigkeit von der Achse der Hauptkeule der Antenne ist, der zweite Eintrag die Elevation des Ziels in Abhängigkeit von der Horizontalität der Antenne ist und der dritte Eintrag der Antennenazimut ist.

7. Verfahren nach Anspruch 6, **dadurch gekennzeichnet, dass** für jede Zelle (Peilwinkel, Elevation) der Tabelle der Fehler der Winkelabweichungsmessung und der Fehler jedes Diagramms durch Mittelungsverfahren, Histogrammverfahren oder andere Verfahren bestimmt werden.

8. Verfahren nach einem der vorhergehenden Ansprüche, **dadurch gekennzeichnet, dass** der gegebene Zeitraum so definiert wird, dass laufende Leistungsrückgänge der Diagramme sichtbar werden.

9. Verfahren nach einem der vorhergehenden Ansprüche, **dadurch gekennzeichnet, dass** die Tabelle auf Grundlage der gemessenen Fehler der Winkelabweichungsmessung korrigiert wird, um eine gute azimutale Präzision des Radars bei einem Leistungsrückgang der Gruppe der als zur Luft gehörig bezeichneten Komponenten zu gewährleisten, wobei; unter der Kontrolle eines Bedieners oder automatisch, der Radar eine Tabelle der Fehler der Winkelabweichungsmessung verwendet, um die Synchronziele im Azimut in dem Hauptstrahl zu lokalisieren.

10. Verfahren nach einem der vorhergehenden Ansprüche, **dadurch gekennzeichnet, dass** die Antenne, mit der ein Sekundärradar vom Typ ATC oder IFF ausgestattet ist, mindestens zwei Diagramme aufweist.

11. Verfahren nach einem der vorhergehenden Ansprüche, **dadurch gekennzeichnet, dass** die Antenne (1) eine Fest- oder Drehantenne mit Strahlschwenkung ist.

12. Verfahren nach einem der vorhergehenden Ansprüche, **dadurch gekennzeichnet, dass** die Messungen des Fehlers der Winkelabweichungsmessung und der Antennendiagramme verwendet werden, um das Ausmaß des Leistungsrückgangs jedes Luftelements zu bewerten: Antenne, Antennezuführung, Drehverbindung.

13. Verfahren nach einem der vorhergehenden Ansprüche, **dadurch gekennzeichnet, dass** die Messung der Diagramme verwendet wird, um das Ausmaß des Leistungsrückgangs der Gruppe der als zur Luft gehörig bezeichneten Komponenten zu bewerten.

14. Sekundärradar, **dadurch gekennzeichnet, dass** er in der Lage ist, das Verfahren nach einem der vorhergehenden Ansprüche auszuführen.

## Claims

1. Method for measuring antenna patterns (1) and angle error measurement by elevation segments of a secondary radar, each pattern (11, 12, 14, 15) being associated with a reception channel (5), **characterized in that**, over a given time period,
- the unsolicited asynchronous replies (61), of long ADS-B squitters type, transmitted by targets present in the airborne environment of said radar, are detected, each of said squitters containing 3D position information on the target which transmits it;
- for each detection, the long ADS-B squitter is decoded to check that the detected target is located in accordance with the position information contained in said squitter, the non-conforming detections being rejected;
- for each detection retained, the time of said detection, the value of the azimuth of the axis of the main beam of said antenna, the angle error measurement voltage and the received power value (61, 611, 612) on each of said SUM, DIFF, CONT_Front, CONT_Back reception channels are associated with said detection, the position information contained in said squitter giving, by calculation, the elevation segment in which said detection is situated;
said values obtained over said period being stored, the measured patterns (42", 43", 44") and the angle error measurements being sampled, by elevation segment, from said stored values.

2. Method according to Claim 1, **characterized in that** said antenna comprises one of the following sets of patterns:
- a sum pattern (SUM), a difference pattern (DIFF), a control pattern for rejecting replies from targets facing the antenna (CONT_Front) and a control pattern for rejecting targets behind the antenna (CONT_Back);
- a sum pattern (SUM), a difference pattern (DIFF), a control pattern (CONT);
- a sum pattern (SUM) and a difference and control pattern (DIFF/CONT).

3. Method according to either one of Claims 1 and 2, **characterized in that** the replies of long ADS-B squitters type are enriched by characteristics representative of the acquisition of said replies, said characteristics being, for each reply, at least one of the following characteristics:
- the received power according to each pattern of said antenna;
- the angle error measurement of the reply in the main lobe of said antenna;
- the time of the detection of said reply;
- the azimuth of the axis of the main beam of said antenna upon said detection.

4. Method according to Claim 3, **characterized in that**, for each squitter received in the main beam, said method:
- exploits the information contained in the squitter;
- calculates the relative power then the error of the gain of the patterns of the antenna as a function of the relative bearing:
• in the same beam, said radar measuring the power of the synchronous plot, said power being the maximum value of the sum pattern;
• the long ADS-B squitter reply being enriched with a measurement of power on the sum, difference and control patterns, the method according to the invention deducing, for the relative bearing of the squitter:
∘ SUM-relative (dB) = SUM (in dBm) - SUM_max (in dBm);
∘ DIFF-relative (dB) = DIFF (in dBm) - SUM_max (in dBm);
∘ CONT-relative (dB) = CONT (in dBm) - SUM_max (in dBm);
• the gain error of each pattern is established by comparing these values to those of reference of the invention (patterns measured either on receipt of the radar in the factory, or on acceptance of the radar site):
∘ SUM_err (dB) = SUM-relative (dB) - SUM-reference (dB);
∘ DIFF_err (dB) = DIFF-relative (dB) - DIFF-reference (dB);
∘ CONT_err (dB) = CONT-relative (dB) - CONT-reference (dB);
- calculates the angle error measurement error by taking account of the deformation of the beam in elevation relative to the antenna.

5. Method according to any one of the preceding claims, **characterized in that**, for the duration of the analysis, said values are accumulated as a function of the relative bearing over time according to:
- the azimuth of said antenna;
- the elevation of said target.

6. Method according to any one of the preceding claims, **characterized in that**, over said given period, the angle error measurement error and the error of each pattern are accumulated in tables with three inputs, one table being associated with the angle error measurement error and with the error of each antenna pattern, one input being the relative bearing as a function of the axis of the main lobe of the antenna, the second input being the elevation of the target as a function of the horizontal alignment of the antenna and the third input being the antenna azimuth.

7. Method according to Claim 6, **characterized in that**, for each cell (relative bearing, elevation) of said table, the angle error measurement error and the error of each pattern are established by methods of average, histogram or other type.

8. Method according to any one of the preceding claims, **characterized in that** said given period is defined to reveal current degradations of said patterns.

9. Method according to any one of the preceding claims, **characterized in that**, under the control of an operator or automatically, said radar employing an angle error measurement table to locate the synchronous targets in azimuth in said main beam, said table is corrected on the basis of the measured angle error measurement errors in order to ensure a good azimuth accuracy of said radar in the event of a degradation of the set of components called aerial.

10. Method according to any one of the preceding claims, **characterized in that** the antenna, with which a secondary radar of ATC or IFF type is equipped, comprises at least two patterns.

11. Method according to any one of the preceding claims, **characterized in that** said antenna (1) is a fixed or rotating electronically scanned antenna.

12. Method according to any one of the preceding claims, **characterized in that** the measurements of the angle error measurement error and of the antenna patterns are used to evaluate the level of degradation for each element of the aerial: antenna, downlead cables, rotating joint.

13. Method according to any one of the preceding claims, **characterized in that** the measurement of said patterns is used to evaluate the level of degradation of the set of components called aerial.

14. Secondary radar, **characterized in that** it is capable of implementing the method according to any one of the preceding claims.
